# EUROPEAN PATENT APPLICATION

(11) **EP 2 999 063 A1**
(43) Date of publication of application: **23.03.2016**
(21) Application number: 13887207.2
(22) Date of filing: 18.06.2013
(51) Int. Cl.: H01S 5/026, H01S 5/06

(54) **OPTICAL COMPONENT, LASER, OPTICAL NETWORK SYSTEM AND MONITORING METHOD**

(71) Applicant: Huawei Technologies Co., Ltd., Longgang District Shenzhen, Guangdong 518129 (CN)
(72) Inventor: WANG, Lei, Shenzhen, Guangdong 518129 (CN); ZHOU, Xiaoping, Shenzhen, Guangdong 518129 (CN)
(74) Representative: Pfenning, Meinig & Partner mbB
(86) International application number: PCT/CN2013/077366
(87) International publication number: WO 2014/201616

(57) **Abstract**

An optical component (10), a laser (30), an optical network system (40), and a monitoring method are disclosed. The optical component includes a filter (101), a first detector (102), a second detector (103), an optical beamsplitter (104), and a processor (105). The filter (101) reflects an incident optical signal to the optical beamsplitter (104) and transmits the incident optical signal to the second detector (103); the optical beamsplitter (104) splits a reflected optical signal and make one beam thereof incident to the first detector (102); the first detector (102) monitors the reflected optical signal, to obtain an optical power of the reflected optical signal, and sends the optical power of the reflected optical signal to the processor (105); the second detector (103) is configured to monitor a transmitted optical signal, to obtain an optical power of the transmitted optical signal, and send the optical power of the transmitted optical signal to the processor (105); and the processor (105) adjusts the optical power of the reflected optical signal and the optical power of the transmitted optical signal, to minimize a ratio of the optical power of the reflected optical signal to the optical power of the transmitted optical signal, thereby monitoring a side mode suppression ratio and extending a service life of a laser.

## Description

### TECHNICAL FIELD

The present invention relates to the field of communications technologies, and in particular, to an optical component, a laser, an optical network system, and a monitoring method.

### BACKGROUND

CAt present, a 40 G time and wavelength division multiplexing (Time and wavelength division multiplexed, TWDM) passive optical network is initially identified as a standard architecture of the next-generation passive optical network. In the 40 G TWDM PON, one of key technologies is implementing an adjustable optical network unit.

A most important part of the adjustable optical network unit is an adjustable laser whose wavelength is tunable. At present, a distributed Bragg reflector (Distributed Feedback Reflector, DBR) laser is usually used for an application with a relatively small tuning range.

The existing DBR laser is calibrated before delivery, so as to meet operating conditions of the DRB laser. After delivery, operating current of each section is selected in a table look-up manner, so as to set the DBR laser to a target operating wavelength.

However, because of aging and the like, after the DBR laser works for a period of time, detuning may occur. When the DBR laser is relatively heavily aged, a problem that a main mode of the DBR laser deviates from a DBR reflection peak wavelength is highlighted, which leads to a decreased loss difference between the main mode and a side mode of the DBR laser, thereby causing that a side mode suppression ratio of the DBR laser deteriorates, and severely affecting precision and a service life of the DBR laser.

### SUMMARY

In view of this, a technical problem mainly resolved in the present invention is to provide an optical component, a laser, an optical network system, and a monitoring method, which can easily and effectively monitor a side mode suppression ratio.

A first aspect provides an optical component, where the optical component includes: a filter, a first detector, a second detector, an optical beamsplitter, and a processor, where an input end of the optical beamsplitter is connected to one end of the filter, an output end of the optical beamsplitter is connected to an input end of the first detector, the other end of the filter is connected to an input end of the second detector, and the processor is connected to both an output end of the first detector and an output end of the second detector, where: the filter is configured to reflect and transmit an incident optical signal, so that a reflected optical signal is incident to the optical beamsplitter and a transmitted optical signal is incident to the second detector; the optical beamsplitter is configured to split the optical signal, reflected by the filter, into at least two beams of reflected optical signals, and make any one beam of reflected optical signal of the at least two beams of reflected optical signals incident to the first detector; the first detector is configured to monitor the reflected optical signal sent by the optical beamsplitter, to obtain an optical power of the reflected optical signal, and send the optical power of the reflected optical signal to the processor; the second detector is configured to monitor the transmitted optical signal sent by the filter, to obtain an optical power of the transmitted optical signal, and send the optical power of the transmitted optical signal to the processor; and the processor is configured to receive the optical power of the reflected optical signal and the optical power of the transmitted optical signal, and adjust the optical power of the reflected optical signal and the optical power of the transmitted optical signal, to minimize a ratio of the optical power of the reflected optical signal to the optical power of the transmitted optical signal.

With reference to the implementation manner of the first aspect, in a first possible implementation manner, the processor adjusts the optical power of the reflected optical signal and the optical power of the transmitted optical signal specifically by adjusting a current value of injected current, so as to minimize the ratio of the optical power of the reflected optical signal to the optical power of the transmitted optical signal.

With reference to the implementation manner of the first aspect, in a second possible implementation manner, the optical beamsplitter is a Y-shaped splitter, a multi-mode interference coupler, or a tilted splitting etching groove.

A second aspect provides a laser, where the laser includes a phase region, a gain region, and the optical component described above.

With reference to the implementation manner of the second aspect, in a first possible implementation manner, the processor of the optical component is specifically configured to: when a ratio of an optical power of a reflected optical signal to an optical power of a transmitted optical signal does not reach the minimum, adjust the optical power of the reflected optical signal and the optical power of the transmitted optical signal by adjusting a current value of injected current on the phase region; and the phase region is configured to adjust, by adjusting the current value of the injected current, an optical power of an optical signal incident to the filter of the optical component, so as to minimize the ratio of the optical power of the reflected optical signal to the optical power of the transmitted optical signal.

A third aspect provides an optical network system, where the optical network system includes at least an optical line terminal, an optical distribution network, and an optical network unit, where the optical line terminal is connected to the optical network unit by using the optical distribution network, and the optical line terminal and/or the optical network unit includes the optical component described above.

A fourth aspect provides a monitoring method, applied in a laser, where the monitoring method includes: reflecting and transmitting an incident optical signal; splitting one beam of reflected optical signal into at least two beams of reflected optical signals; monitoring any one beam of reflected optical signal of the at least two beams of reflected optical signals, to obtain an optical power of the reflected optical signal; monitoring a transmitted optical signal, to obtain an optical power of the transmitted optical signal; and adjusting the optical power of the reflected optical signal and the optical power of the transmitted optical signal, to minimize a ratio of the optical power of the reflected optical signal to the optical power of the transmitted optical signal.

With reference to the implementation manner of the fourth aspect, in a first possible implementation manner, the adjusting the optical power of the reflected optical signal and the optical power of the transmitted optical signal specifically includes: when it is determined that the ratio of the optical power of the reflected optical signal to the optical power of the transmitted optical signal does not reach the minimum, adjusting the optical power of the reflected optical signal and the optical power of the transmitted optical signal by adjusting a current value of injected current.

By using the foregoing solutions, beneficial effects of the present invention are: in the present invention, a filter reflects and transmits an incident optical signal, so that a reflected optical signal is incident to an optical beamsplitter and a transmitted optical signal is incident to a second detector; the optical beamsplitter splits the optical signal, reflected by the filter, into at least two beams of reflected optical signals, and make any one beam of reflected optical signal of the at least two beams of reflected optical signals incident to a first detector; the first detector monitors the reflected optical signal sent by the optical beamsplitter and sends an optical power of the reflected optical signal to a processor; the second detector monitors the transmitted optical signal sent by the filter and sends an optical power of the transmitted optical signal to the processor; and the processor adjusts the optical power of the reflected optical signal and the optical power of the transmitted optical signal, to minimize a ratio of the optical power of the reflected optical signal to the optical power of the transmitted optical signal. By using the foregoing manner, the present invention can effectively monitor a side mode suppression ratio and extend a service life of a laser.

### BRIEF DESCRIPTION OF DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a schematic structural diagram of an optical component according to a first embodiment of the present invention;
FIG. 2 is a schematic structural diagram of an optical component according to a second embodiment of the present invention;
FIG. 3 is a schematic structural diagram of a laser according to a third embodiment of the present invention;
FIG. 4 is a schematic structural diagram of an optical network system according to a fourth embodiment of the present invention; and
FIG. 5 is a flowchart of a monitoring method according to a fifth embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

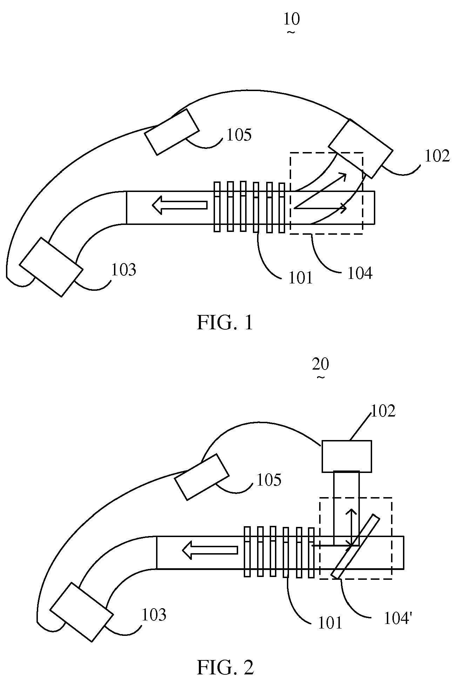

Referring to FIG. 1, FIG. 1 is a schematic structural diagram of an optical component according to a first embodiment of the present invention. As shown in FIG. 1, the optical component 10 of the present invention includes a filter 101, a first detector 102, a second detector 103, an optical beamsplitter 104, and a processor 105. An input end of the optical beamsplitter 104 is connected to one end of the filter 101, an output end of the optical beamsplitter 104 is connected to an input end of the first detector 102, the other end of the filter 101 is connected to an input end of the second detector 103, and the processor 105 is connected to both an output end of the first detector 102 and an output end of the second detector 103.

In this embodiment, the filter 101 is configured to reflect and transmit an incident optical signal, so that a reflected optical signal is incident to the optical beamsplitter 104 and a transmitted optical signal is incident to the second detector 103. The filter 104 may be a distributed Bragg reflector (Distributed Bragg Reflector, DBR), an arrayed waveguide grating (arrayed waveguide grating, AWG), or the like.

The optical beamsplitter 104 is configured to split the optical signal, reflected by the filter 101, into at least two beams of reflected optical signals, and make any one beam of reflected optical signal of the at least two beams of reflected optical signals incident to the first detector 102. The optical beamsplitter 104 is a Y-shaped splitter, a multi-mode interference coupler, or a tilted splitting etching groove. By using the multi-mode interference coupler, deviation tolerance of the optical beamsplitter on size can be improved.

The first detector 102 is configured to monitor the reflected optical signal sent by the optical beamsplitter 104, to obtain an optical power of the reflected optical signal, and send the optical power of the reflected optical signal to the processor 105. The first detector 102 may be an optoelectronic detector, or the like.

The second detector 103 is configured to monitor the transmitted optical signal sent by the filter 101, to obtain an optical power of the transmitted optical signal, and send the optical power of the transmitted optical signal to the processor 105. The second detector 103 may be an optoelectronic detector, or the like.

The processor 105 is configured to receive the optical power of the reflected optical signal and the optical power of the transmitted optical signal, and adjust the optical power of the reflected optical signal and the optical power of the transmitted optical signal, to minimize a ratio of the optical power of the reflected optical signal to the optical power of the transmitted optical signal.

Further, the processor 105 adjusts the optical power of the reflected optical signal and the optical power of the transmitted optical signal specifically by adjusting a current value of injected current, so as to minimize the ratio of the optical power of the reflected optical signal to the optical power of the transmitted optical signal. A specific process of adjusting, by the processor 105, the injected current to change the optical power of the transmitted optical signal and the optical power of the reflected optical signal is described as a third embodiment in the following, and no further details are provided herein again.

In the optical component 10 of the present invention, a filter 101 reflects and transmits an incident optical signal, so that a reflected optical signal is incident to an optical beamsplitter 104 and a transmitted optical signal is incident to a second detector 103; the optical beamsplitter 104 splits the optical signal, reflected by the filter 101, into at least two beams of reflected optical signals, and make any one beam of reflected optical signal of the at least two beams of reflected optical signals incident to a first detector 102; the first detector 102 monitors the reflected optical signal sent by the optical beamsplitter 104 and sends an optical power of the reflected optical signal to a processor 105; the second detector 103 monitors the transmitted optical signal sent by the filter 101 and sends an optical power of the transmitted optical signal to the processor 105; and the processor 105 adjusts the optical power of the reflected optical signal and the optical power of the transmitted optical signal, to minimize a ratio of the optical power of the reflected optical signal to the optical power of the transmitted optical signal. Therefore, the present invention can easily and effectively monitor a side mode suppression ratio.

Referring to FIG. 2, FIG. 2 is a schematic structural diagram of an optical component according to a second embodiment of the present invention. As shown in FIG. 2, the optical component 20 includes the filter 101, the first detector 102, the second detector 103, and the processor 105 that are shown in FIG. 1, and a tilted splitting etching groove 104'. A function of the tilted splitting etching groove 104' is the same as that of the optical beamsplitter 104 in FIG. 1, and the tilted splitting etching groove 104' is a specific implementation of the optical beamsplitter 104. A tilt degree of the tilted splitting etching groove 104' is preferably 45 degrees. The tilted splitting etching groove 104' can reduce an impact of a cavity length of the laser. For functions of other components, refer to the descriptions in FIG. 1, and no further details are provided herein again.

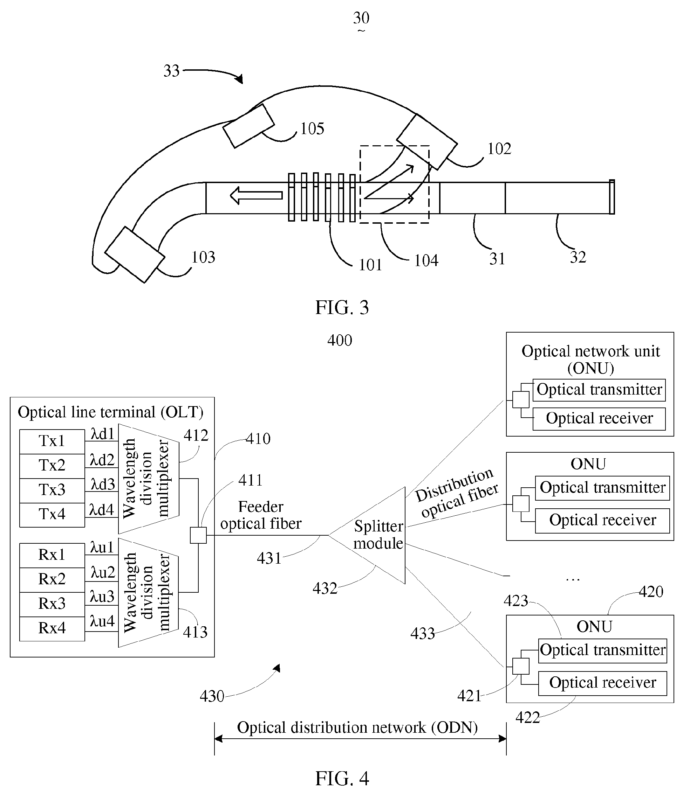

Referring to FIG. 3, FIG. 3 is a schematic structural diagram of a laser according to a third embodiment of the present invention. As shown in FIG. 3, a laser 30 of the present invention includes a phase region 31, a gain region 32, and an optical component 33. The optical component 33 includes at least the filter 101, the first detector 102, the second detector 103, the optical beamsplitter 104, and the processor 105 that are shown in FIG. 1 or FIG. 2.

Further, when the laser 30 works, a reflection peak wavelength of the filter 101 is adjusted to a target wavelength by injecting current to the phase region 31. The gain region 32 is configured to provide a gain for the laser 30.

Further, the phase region 31 is configured to adjust, by adjusting a current value of the injected current, an optical power of an optical signal incident to the filter 101 of the optical component 33, to minimize a ratio of an optical power of a reflected optical signal to an optical power of a transmitted optical signal.

Specifically, when determining that the ratio of the optical power of the reflected optical signal to the optical power of the transmitted optical signal does not reach the minimum, the processor 105 of the optical component 33 adjusts the optical power of the reflected optical signal and the optical power of the transmitted optical signal by adjusting the current value of the injected current on the phase region 31.

Further, the phase region 31 slightly adjusts a phase of the laser 30 by changing the injected current on the phase region 31, so as to minimize the ratio of the optical power of the reflected optical signal to the optical power of the transmitted optical signal. When the ratio of the optical power of the reflected optical signal to the optical power of the transmitted optical signal is the minimum, a main mode of the laser 30 is aligned with the reflection peak wavelength of the filter 101, that is, a side mode suppression ratio (Side Mode Suppression Ratio, SMSR) between the main mode of the laser 30 and a side mode of the filter 101 is monitored rapidly and easily by controlling current on the phase region 31 of the laser 30, so that the SMSR of the laser 30 reaches a highest point, thereby implementing single wavelength operation of the laser 30 and extending a service life of the laser 30.

Further, a process in which the processor 105 further adjusts the current on the phase region 31 to change the optical power of the transmitted optical signal and the optical power of the reflected optical signal is as follows:

In a first case, if the processor 105 determines, when increasing a present current value of the phase region 31, that a ratio between the optical power of the reflected power signal and the optical power of the transmitted power signal that are returned by the first detector 102 and the second detector 103 is decreased compared with the ratio obtained before the processor 105 adjusts the current on the phase region 31, the processor 105 continues to increase the current value of the phase region 31 until the ratio between the optical power of the transmitted optical signal and the optical power of the reflected optical signal reaches the minimum.

In a second case, if the processor 105 determines, when increasing a present current value of the phase region 31, that a ratio between the optical power of the transmitted power signal and the optical power of the reflected power signal that are returned by the second detector 103 and the first detector 102 is increased compared with the ratio obtained before the processor 105 adjusts the current on the phase region 31, the processor 105 decreases the current value of the phase region 31 until the ratio between the optical power of the transmitted optical signal and the optical power of the reflected optical signal reaches the minimum.

In a third case, if the processor 105 determines, when decreasing a present current value of the phase region 31, that a ratio between the optical power of the transmitted power signal and the optical power of the reflected power signal that are returned by the second detector 103 and the first detector 102 is decreased compared with the ratio obtained before the processor 105 adjusts the current on the phase region 31, the processor 105 decreases the current value of the phase region 31 until the ratio between the optical power of the transmitted optical signal and the optical power of the reflected optical signal reaches the minimum.

In a fourth case, if the processor 105 determines, when decreasing a present current value of the phase region 31, that a ratio between the optical power of the transmitted power signal and the optical power of the reflected power signal that are returned by the second detector 103 and the first detector 102 is increased compared with the ratio obtained before the processor 105 adjusts the current on the phase region 31, the processor 105 increases the current value of the phase region 31 until the ratio between the optical power of the transmitted optical signal and the optical power of the reflected optical signal reaches the minimum.

A present current value of a phase region 31 is adjusted, and then a processor 105 determines how a ratio of an optical power of a transmitted optical signal to an optical power of a reflected optical signal changes compared with a ratio obtained before adjusting a current on the phase region 31, so as to further adjust the current value of the phase region 31 until the ratio of the optical power of the transmitted optical signal to the optical power of the reflected optical signal reaches the minimum. Therefore, a side mode suppression ratio can be easily and effectively monitored and a service life of a laser 30 can be extended.

Referring to FIG. 4, FIG. 4 is a schematic structural diagram of an optical network system according to a fourth embodiment of the present invention. Specifically, an optical network system 400 may be a multiple wavelength passive optical network (Multiple Wavelength PON, MWPON) system. The optical network system 400 includes at least one optical line terminal (Optical Line Terminal, OLT) 410, multiple optical network units (Optical Network Unit, ONU) 420, and an optical distribution network (Optical Distribution Network, ODN) 430. The optical line terminal 410 is connected to the multiple optical network units 420 by using the optical distribution network 430 in a point-to-multipoint manner. The multiple optical network units 420 share an optical transmission medium of the optical distribution network 430. The optical distribution network 430 may include a feeder optical fiber 431, an optical power splitter module 432, and multiple distribution optical fibers 433. The optical power splitter module 432 may be disposed at a remote node (Remote Node, RN). In one aspect, the optical power splitter module 432 is connected to the optical line terminal 410 by using the feeder optical fiber 431, and in another aspect, the optical power splitter module 432 is connected to the multiple optical network units 420 by using the multiple distribution optical fibers 433. A direction from the OLT to the ONU is referred to as downlink, and a direction from the ONU to the OLT is referred to as uplink.

Further, in the optical network system 400, communication links between the optical line terminal 410 and the multiple optical network units 420 may include multiple wavelength paths, and the multiple wavelength paths share the optical transmission medium of the optical distribution network 430 in a wavelength division multiplexing (Wave-Division Multiplexing, WDM) manner. Each optical network unit 420 may work on one wavelength path of the multiple wavelength passive optical network system 400, and each wavelength path may carry services of one or more optical network units 420. In addition, optical network units 420 working on a same wavelength path may share the wavelength path in a time division multiplexing (Time-Division Multiplexing, TDM) manner. In this embodiment, as shown in FIG. 4, introduction is made by using an example in which the multiple wavelength passive optical network system 400 has four wavelength paths, and it should be noted that, in actual application, a quantity of wavelength paths of the optical network system 400 may be set according to network requirements.

Further, the optical line terminal 410 may include an optical coupler 411, a first wavelength division multiplexer 412, a second wavelength division multiplexer 413, multiple downlink optical transmitters Tx1 to Tx4, and multiple uplink optical receivers Rx1 to Rx4. The multiple downlink optical transmitters Tx1 to Tx4 are connected to the optical coupler 411 by using the first wavelength division multiplexer 412, the multiple uplink optical receivers Rx1 to Rx4 are connected to the optical coupler 411 by using the second wavelength division multiplexer 413, and the optical coupler 411 is further connected to the feeder optical fiber 431 of the optical distribution network 430.

Transmit wavelengths of the multiple downlink optical transmitters Tx1 to Tx4 are different from each other, where each of the multiple downlink optical transmitters Tx1 to Tx4 may correspond to one wavelength path of the optical network system 400, for example, the transmit wavelengths of the multiple downlink optical transmitters Tx1 to Tx4 may be λd1 to λd4 respectively. The multiple downlink optical transmitters Tx1 to Tx4 may transmit downlink data to corresponding wavelength paths respectively by using transmit wavelengths λd1 to λd4, so that the downlink data is received by the optical network units 420 working on the wavelength paths. Correspondingly, receive wavelengths of the multiple uplink optical receivers Rx1 to Rx4 may be different from each other, where, similarly, each of the multiple uplink optical receivers Rx1 to Rx4 correspond to one wavelength path of the multiple wavelength passive optical network system 400, for example, the receive wavelengths of the multiple uplink optical receivers Rx1 to Rx4 may be λu1 to λu4 respectively. The uplink optical receivers Rx1 to Rx4 may receive, respectively by using receive wavelengths λu1 to λu4, uplink data sent by the optical network units 420 working on corresponding wavelength paths.

The first wavelength division multiplexer 412 is configured to perform wavelength division multiplexing processing on downlink data whose wavelengths are λd1 to λd4 respectively and that is transmitted by the multiple downlink optical transmitters Tx1 to Tx4, and send the downlink data to the feeder optical fiber 431 of the optical distribution network 430 by using the optical coupler 411, so as to provide the downlink data for the optical network unit 420 by using the optical distribution network 430. In addition, the optical coupler 411 may be further configured to provide, for the second wavelength division multiplexer 413, uplink data whose wavelengths are λd1 to λd4 respectively and that is from the multiple optical network units 420, and the second wavelength division multiplexer 413 may de-multiplex the downlink data whose wavelengths are λd1 to λd4 respectively to the uplink optical receivers Rx1 to Rx4, so that the uplink optical receivers receive the data.

Further, the downlink transmitter and/or the uplink optical receiver of the OLT further includes the laser 30 shown in FIG. 3. The laser 30 includes at least the optical component shown in FIG. 1 or FIG. 2.

Specifically, the optical component includes the filter 101, the first detector 102, the second detector 103, the optical beamsplitter 104, and the processor 105. An input end of the optical beamsplitter 104 is connected to one end of the filter 101, an output end of the optical beamsplitter 104 is connected to an input end of the first detector 102, the other end of the filter 101 is connected to an input end of the second detector 103, and the processor 105 is connected to both an output end of the first detector 102 and an output end of the second detector 103.

In this embodiment, the filter 101 is configured to reflect and transmit an incident optical signal, so that a reflected optical signal is incident to the optical beamsplitter 104 and a transmitted optical signal is incident to the second detector 103. The filter 101 may be a distributed Bragg reflector (Distributed Bragg Reflector, DBR), an arrayed waveguide grating (arrayed waveguide grating, AWG), or the like.

The optical beamsplitter 104 is configured to split the optical signal, reflected by the filter 101, into at least two beams of reflected optical signals, and make any one beam of reflected optical signal of the at least two beams of reflected optical signals incident to the first detector 102. The optical beamsplitter 104 is a Y-shaped splitter, a multi-mode interference coupler, or a tilted splitting etching groove.

The first detector 102 is configured to monitor the reflected optical signal sent by the optical beamsplitter 104, to obtain an optical power of the reflected optical signal, and send the optical power of the reflected optical signal to the processor 105. The first detector 102 may be an optoelectronic detector, or the like.

The second detector 103 is configured to monitor the transmitted optical signal sent by the filter 101, to obtain an optical power of the transmitted optical signal, and send the optical power of the transmitted optical signal to the processor 105. The second detector 103 may be an optoelectronic detector, or the like.

The processor 105 is configured to receive the optical power of the reflected optical signal and the optical power of the transmitted optical signal, and adjust the optical power of the reflected optical signal and the optical power of the transmitted optical signal, to minimize a ratio of the optical power of the reflected optical signal to the optical power of the transmitted optical signal.

Further, the processor 105 adjusts the optical power of the reflected optical signal and the optical power of the transmitted optical signal specifically by adjusting a current value of injected current, so as to minimize the ratio of the optical power of the reflected optical signal to the optical power of the transmitted optical signal. A specific process of adjusting, by the processor 105, the injected current to change the optical power of the transmitted optical signal and the optical power of the reflected optical signal is described as the third embodiment in the foregoing, and no further details are provided herein again.

In the present invention, a filter 101 reflects and transmits an incident optical signal, so that a reflected optical signal is incident to an optical beamsplitter 104 and a transmitted optical signal is incident to a second detector 103; the optical beamsplitter 104 splits the optical signal, reflected by the filter 101, into at least two beams of reflected optical signals, and make any one beam of reflected optical signal of the at least two beams of reflected optical signals incident to a first detector 102; the first detector 102 monitors the reflected optical signal sent by the optical beamsplitter 104 and sends an optical power of the reflected optical signal to a processor 105; the second detector 103 monitors the transmitted optical signal sent by the filter 101 and sends an optical power of the transmitted optical signal to the processor 105; and the processor 105 adjusts the optical power of the reflected optical signal and the optical power of the transmitted optical signal, to minimize a ratio of the optical power of the reflected optical signal to the optical power of the transmitted optical signal. Therefore, the present invention can easily and effectively monitor a side mode suppression ratio and extend a service life of a laser 30.

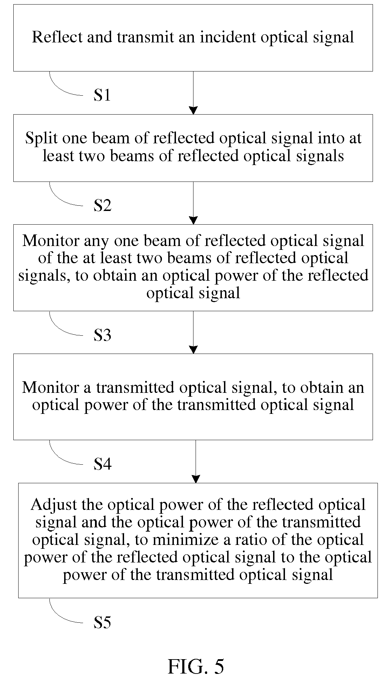

Referring to FIG. 5, FIG. 5 is a flowchart of a monitoring method according to a fifth embodiment of the present invention. The monitoring method is applied in the laser 30 in the third embodiment described above. As shown in FIG. 5, the monitoring method of the present invention includes the following steps:
Step S1: Reflect and transmit an incident optical signal.

Step S2: Split one beam of reflected optical signal into at least two beams of reflected optical signals.

Step S3: Monitor any one beam of reflected optical signal of the at least two beams of reflected optical signals, to obtain an optical power of the reflected optical signal.

Step S4: Monitor a transmitted optical signal, to obtain an optical power of the transmitted optical signal.

Step S5: Adjust the optical power of the reflected optical signal and the optical power of the transmitted optical signal, to minimize a ratio of the optical power of the reflected optical signal to the optical power of the transmitted optical signal.

In step S5, specifically, when it is determined that the ratio of the optical power of the reflected optical signal to the optical power of the transmitted optical signal does not reach the minimum, the optical power of the reflected optical signal and the optical power of the transmitted optical signal are adjusted by adjusting a current value of injected current. A specific process of adjusting the injected current to change the optical power of the transmitted optical signal and the optical power of the reflected optical signal is the same as the third embodiment described above, and no further details are provided herein again.

By using the foregoing manner, this embodiment provided in the present invention can effectively monitor a side mode suppression ratio and extend a service life of a laser.

The foregoing descriptions are merely the embodiments of the present invention, and the protection scope of the present invention is not limited thereto. All equivalent structure or process changes made according to the content of this specification and the accompanying drawings of the present invention or direct or indirect application in other related technical fields shall fall within the protection scope of the present invention.

## Claims

1. An optical component, wherein the optical component comprises: a filter, a first detector, a second detector, an optical beamsplitter, and a processor, wherein an input end of the optical beamsplitter is connected to one end of the filter, an output end of the optical beamsplitter is connected to an input end of the first detector, the other end of the filter is connected to an input end of the second detector, and the processor is connected to both an output end of the first detector and an output end of the second detector, wherein:
the filter is configured to reflect and transmit an incident optical signal, so that a reflected optical signal is incident to the optical beamsplitter and a transmitted optical signal is incident to the second detector;
the optical beamsplitter is configured to split the optical signal, reflected by the filter, into at least two beams of reflected optical signals, and make any one beam of reflected optical signal of the at least two beams of reflected optical signals incident to the first detector;
the first detector is configured to monitor the reflected optical signal sent by the optical beamsplitter, to obtain an optical power of the reflected optical signal, and send the optical power of the reflected optical signal to the processor;
the second detector is configured to monitor the transmitted optical signal sent by the filter, to obtain an optical power of the transmitted optical signal, and send the optical power of the transmitted optical signal to the processor; and
the processor is configured to receive the optical power of the reflected optical signal and the optical power of the transmitted optical signal, and adjust the optical power of the reflected optical signal and the optical power of the transmitted optical signal, to minimize a ratio of the optical power of the reflected optical signal to the optical power of the transmitted optical signal.

2. The optical component according to claim 1, wherein the processor adjusts the optical power of the reflected optical signal and the optical power of the transmitted optical signal specifically by adjusting a current value of injected current, so as to minimize the ratio of the optical power of the reflected optical signal to the optical power of the transmitted optical signal.

3. The optical component according to claim 1, wherein the optical beamsplitter is a Y-shaped splitter, a multi-mode interference coupler, or a tilted splitting etching groove.

4. A laser, wherein the laser comprises at least a phase region, a gain region, and the optical component according to any one of claims 1 to 3.

5. The laser according to claim 4, wherein the processor of the optical component is specifically configured to: when a ratio of an optical power of a reflected optical signal to an optical power of a transmitted optical signal does not reach the minimum, adjust the optical power of the reflected optical signal and the optical power of the transmitted optical signal by adjusting a current value of injected current on the phase region; and
the phase region is configured to adjust, by adjusting the current value of the injected current, an optical power of an optical signal incident to the filter of the optical component, so as to minimize the ratio of the optical power of the reflected optical signal to the optical power of the transmitted optical signal.

6. An optical network system, wherein the optical network system comprises at least an optical line terminal, an optical distribution network, and an optical network unit, wherein the optical line terminal is connected to the optical network unit by using the optical distribution network, and the optical line terminal and/or the optical network unit comprises the optical component according to claims 1 to 3.

7. A monitoring method, applied in a laser, wherein the monitoring method comprises:
reflecting and transmitting an incident optical signal;
splitting one beam of reflected optical signal into at least two beams of reflected optical signals;
monitoring any one beam of reflected optical signal of the at least two beams of reflected optical signals, to obtain an optical power of the reflected optical signal;
monitoring a transmitted optical signal, to obtain an optical power of the transmitted optical signal; and
adjusting the optical power of the reflected optical signal and the optical power of the transmitted optical signal, to minimize a ratio of the optical power of the reflected optical signal to the optical power of the transmitted optical signal.

8. The monitoring method according to claim 7, wherein the adjusting the optical power of the reflected optical signal and the optical power of the transmitted optical signal specifically comprises:
when it is determined that the ratio of the optical power of the reflected optical signal to the optical power of the transmitted optical signal does not reach the minimum, adjusting the optical power of the reflected optical signal and the optical power of the transmitted optical signal by adjusting a current value of injected current.
